# EUROPEAN PATENT APPLICATION

(11) **EP 0 822 596 A2**
(43) Date of publication of application: **04.02.1998**
(21) Application number: 97305850.6
(22) Date of filing: 01.08.1997
(51) Int. Cl.: H01L 27/02

(54) **Improvements in or relating to integrated circuits**

(30) Priority: 02.08.1996 US 23053 P
(71) Applicant: TEXAS INSTRUMENTS INC., Dallas, Texas 75243 (US)
(72) Inventor: Amerasekera, E. Ajith, Plano, Texas 75023 (US)
(74) Representative: Williams, Janice

(57) **Abstract**

An ESD protected semiconductor circuit and the ESD protection circuit. The protected circuit includes a terminal (33), a semiconductor device (31) coupled to the terminal and an ESD protection circuit (35). The ESD protection circuit includes a substrate (1) of a first conductivity type and has a surface (9). A first well (3) of conductivity type opposite to the first conductivity type is disposed within the substrate and extends to the surface. A second well (5) of the first conductivity type is disposed within the first well and is spaced from the substrate and extending to the surface. A third region (7) of the opposite conductivity type is disposed within the second well and is spaced from the first well and extending to the surface. At least one of the substrate or the third region is coupled to the terminal.

## Description

### BACKGROUND OF THE INVENTION

### FIELD OF THE INVENTION

This invention relates to integrated circuits and, more specifically, to ESD protection for semiconductor circuits.

### BRIEF DESCRIPTION OF THE PRIOR ART

Electrostatic discharge (ESD) may cause damage to semiconductor devices in an integrated circuit during handling of the integrated circuit chip package, this being particularly true in the case of MOS circuitry including DRAMs. It is therefore necessary to protect such circuits against damage due to stress conditions such as high energy, high voltage and/or high current pulses. Prevention of such damage generally is provided by protection circuits incorporated into the chip of the integrated circuit. In general, such protection circuits present high impedance or an open circuit therefrom during normal operating conditions of the integrated circuit and switch to low impedance under the above described stress conditions. Such protection circuits generally include a switch which is capable of conducting relatively large currents during an ESD event. Various devices such as silicon controlled rectifiers (SCRs), which are PNPN-type devices, can be and have been utilized to provide the switching function required to essentially shunt the protected circuitry during an ESD event and such prior art devices and a standard manner of fabrication thereof is set forth in US Patent Application No. 08/302,145.

Prior art circuits and structures used for ESD protection can withstand high levels of ESD stress. However, recent advances in technology have produced devices with increasingly smaller geometry. This smaller geometry results in devices which can fail at voltage levels lower than the triggering voltages of prior art protection circuits. Accordingly, improved ESD protection has been sought, one such ESD protection circuit being set forth in the above noted application Serial No. 08/302,145.

### SUMMARY OF THE INVENTION

Respective aspects of the present invention are set forth in claims 1 and 5.

Embodiments of the present invention provide an arrangement for ESD protection which overcomes the above noted problems using minimum area and providing maximized protection levels.

Briefly, this can be accomplished by providing a triple well to form vertical bipolar/SCR structures in a CMOS process. The vertical structures allow better power dissipation and higher ESD levels than do lateral structures. The triple well is formed in a doped substrate using the techniques of the prior art for formation of wells in a substrate and/or within another well. Each successive well is of opposite conductivity type from the substrate or the well in which it is formed and each of the wells together with the substrate has a region extending to a single upper surface of the device being fabricated. The substrate can be n-type or p-type with the formed wells then being alternately of conductivity type different from and then the same as the substrate. The last well or region formed can be more highly doped to avoid the step of forming a highly doped contact region therein. The result is a vertical PNPN structure which also has access to all of the regions from the top surface.

### BRIEF DESCRIPTION OF THE DRAWINGS

Embodiments of the invention will now be further described, by way of example, with reference to the accompanying drawings in which:
FIGURE 1a is a cross-sectional view of a partially fabricated PNPN SCR structure having ESD protection;
FIGURE 1b is a view as in FIGURE 1a of a completed SCR structure embodying the present invention;
FIGURE 1c is a schematic diagram of the circuit of FIGURE 1b;
FIGURE 2 is a schematic diagram of the completed device of FIGURE 1b;
FIGURE 3 is a device as in FIGURE 1b but with the n-type regions changed to p-type and the p-type regions changed to n-type;
FIGURE 4 (a) is a schematic diagram showing the ESD protection circuit of the present embodiment used in conjunction with an MOS transistor for protection of the input transistor; and
FIGURE 4(b) is a schematic diagram showing the ESD protection circuit of the present embodiment used in conjunction with an MOS transistor for protection of the output transistor.

### DESCRIPTION OF THE PREFERRED EMBODIMENT

Referring to FIGURE la, there is shown a starting structure which is fabricated by standard patterning and doping and includes a p-type substrate 1 having a first n-type well 3 therein. A p-type well 5 is formed within the first n-well 3 and a second n-type well or region 7 is formed within the p-well 5. All of the wells 3, 5 and 7 extend to the upper surface 9 of the substrate 1 and a portion of the substrate is also exposed at the upper surface. It should be understood that an equivalent device can be made starting with an n-type substrate with the conductivity types of the wells being reversed and such embodiment is also contemplated in accordance with the present invention.

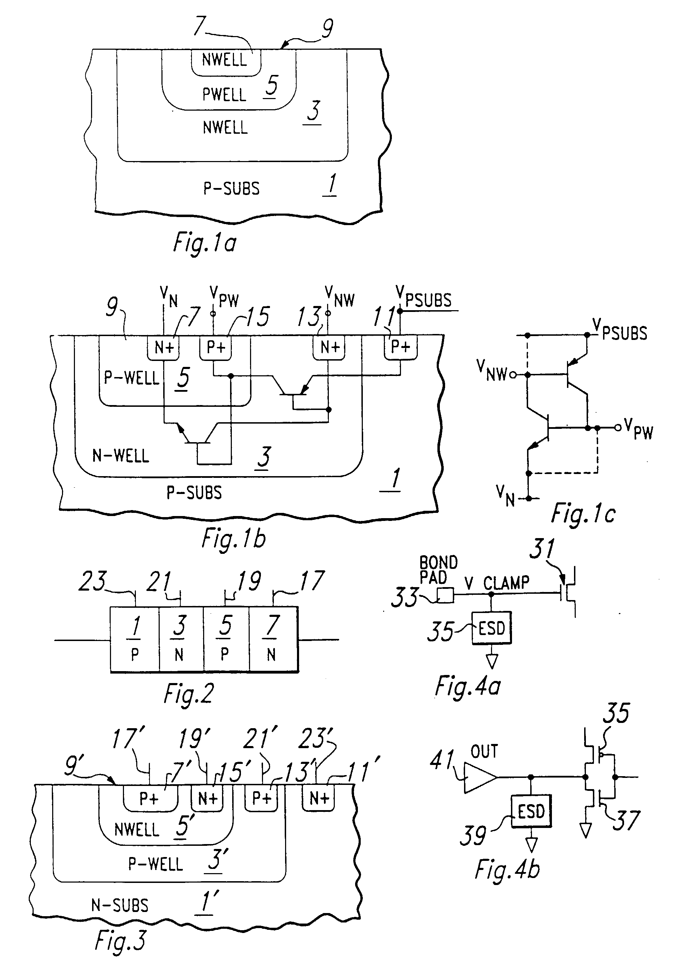

Referring now to FIGURES 1(b) and 1(c), a p+ contact region 11 is formed at the surface 9 of the substrate 1, an n+ contact region 13 is formed at the surface 9 of the n-well 3 and a p+ contact region 15 is formed at the surface 9 of the p-well 5, the n-well or region 7 having been initially doped to n+ level by appropriate standard masking and doping. Pads and/or leads are provided to the contact regions in standard manner, there being a V_{N} lead 17 to the n-well, a V_{PW} lead 19 to the contact 15, a V_{NW} lead 21 to the contact 13 and a V_{SUBS} lead 23 to the contact 11. It can be seen that two bipolar transistors have been formed, one such transistor being an NPN transistor including regions 3, 5 and 7 and the other such transistor being a PNP transistor including regions 1, 3 and 5. The common regions 3 and 5 result in the final PNPN SCR structure .

To turn the SCR of FIGURE 1b "ON", it is necessary to forward bias any of the junctions such as the junction between the n-well 3 and the substrate 1, the junction between the p-well 5 and the n-well 3 or the junction between the p-well 5 and the n-well or region 7. The requirement for SCR conduction is to first turn "ON" the PNP transistor portion of the SCR, this including the substrate 1, the n-well 3 and the p-well 5 or the NPN transistor portion of the SCR, this including the n-well 3, the p-well 5 and the second n-well or region 7. Turn-ON is accomplished by raising the voltage at terminal 23 above the voltage of the n-well 3 or by lowering the voltage at terminal 17 below that at the p-well 5, thereby injecting current into the base of either the PNP transistor or the NPN transistor. The turn-ON voltage is very low relative to the prior art SCR ESD protection circuits because the turn-ON voltage is merely the voltage between terminal 23 and the n-well 3 or between terminal 17 and the p-well 5.

The final structure, as shown in FIGURE 2, from an electrical perspective, is a PNPN device with leads available from each of the regions 1, 3, 5 and 7.

Referring now to FIGURE 3, there is shown a structure which is identical to that of FIGURE 1b except that the p-type regions have been changed to n-type and the n-type regions have been changed to p-type and with all reference characters referring to the same structures as in FIGURE 1b being the same except that they are primed (').

Referring now to FIGURE 4(a), there is shown typical ESD protection of an MOS transistor 31 with an ESD protection circuit 35. The ESD protection circuit normally is "OFF", thereby providing a very high impedance to ground. When the voltage at the bond pad 33 becomes excessive, the voltage thereon is applied to the ESD circuit 35 and specifically to the terminals 17,19 and 21,23 to turn "ON" one of the PNP or NPN transistors and shunt the current around the MOS transistor 31, thereby avoiding damage to the MOS transistor.

Referring now to FIGURE 4(b), there is shown typical ESD protection of PMOS transistor 35 and NMOS transistor 37 (or both transistors can be NMOS) with an ESD protection circuit 39. The ESD protection circuit normally is "OFF", thereby providing a very high impedance to ground. When the voltage at the bond pad 41 becomes excessive, the voltage thereon is applied to the ESD circuit 35 and specifically to the terminals 17,19 and 21, 23 to turn "ON" one of the PNP or NPN transistors and shunt the current around the MOS transistors 35 and 37, thereby avoiding damage to the MOS transistors.

Though the invention has been described with reference to specific preferred embodiments thereof, many variations and modifications will immediately become apparent to those skilled in the art.

## Claims

1. An ESD protected semiconductor circuit comprising:
a semiconductor device coupled to a terminal; and and an ESD protection circuit comprising:
(i) a substrate of a first conductivity type;
(ii) a first well of conductivity type opposite to said first conductivity type disposed within said substrate and extending to a surface thereof;
(iii) a second well of said first conductivity type disposed within said first well and spaced from said substrate and extending to said surface; and
(iv) a third region of said opposite conductivity type disposed within said second well and spaced from said first well and extending to said surface; and
wherein at least one of said substrate or said third region coupled to said terminal.

2. The circuit of Claim 1, wherein said semiconductor device is an MOS transistor.

3. The circuit of Claim 1 or Claim 2, wherein said first conductivity type is p-type.

4. The circuit of Claim 1 or Claim 2, wherein said first conductivity type is n-type.

5. An ESD protection circuit comprising:
a substrate of a first conductivity type;
a first well of conductivity type opposite to said first conductivity type disposed within said substrate and extending to a surface thereof;
a second well of said first conductivity type disposed within said first well and spaced from said substrate and extending to said surface; and
a third region of said opposite conductivity type disposed within said second well and spaced from said first well and extending to said surface.

6. The circuit of Claim 5, wherein said semiconductor device is an MOS transistor.

7. The circuit of Claim 5 or Claim 6, wherein said first conductivity type is p-type.

8. The circuit of Claim 5 or Claim 6, wherein said first conductivity type is n-type.
